(19) Europäisches Patentamt
European Patent Office
Office européen des brevets

(11) **EP 0 731 984 B1**

(12) **EUROPÄISCHE PATENTSCHRIFT**

(45) Veröffentlichungstag und Bekanntmachung des Hinweises auf die Patenterteilung:
**04.10.2001 Patentblatt 2001/40**

(51) Int Cl.[7]: **H01L 23/31**, H01L 23/492, H01L 23/24

(21) Anmeldenummer: **95901331.9**

(22) Anmeldetag: **26.11.1994**

(86) Internationale Anmeldenummer:
**PCT/DE94/01400**

(87) Internationale Veröffentlichungsnummer:
**WO 95/15578 (08.06.1995 Gazette 1995/24)**

(54) **GLEICHRICHTERDIODE**

RECTIFIER DIODE

DIODE DE REDRESSEMENT

(84) Benannte Vertragsstaaten:
**DE FR IT**

(30) Priorität: **03.12.1993 DE 4341269**

(43) Veröffentlichungstag der Anmeldung:
**18.09.1996 Patentblatt 1996/38**

(73) Patentinhaber: **ROBERT BOSCH GMBH
70442 Stuttgart (DE)**

(72) Erfinder: **SPITZ, Richard
D-72766 Reutlingen (DE)**

(56) Entgegenhaltungen:
**FR-A- 2 138 070        GB-A- 1 173 737**

EP 0 731 984 B1

**Beschreibung**

Die Erfindung betrifft eine Gleichrichterdiode nach dem Oberbegriff des Anspruchs 1.

Stand der Technik

Es ist bekannt, Gleichrichterdioden für mittlere und höhere Leistungen als Einpreßdioden auszuführen. Die Einpreßdioden weisen dabei einen Einpreßsockel auf, der in eine entsprechende Ausnehmung eines Befestigungselementes eingepreßt wird. Das Befestigungselement übernimmt dabei gleichzeitig eine dauerhafte thermische und elektrische Verbindung der Gleichrichterdiode. Derartige Anordnungen sind beispielsweise aus der Kraftfahrzeugtechnik bekannt, wo sie als Gleichrichter in Kraftfahrzeuggeneratoren eingesetzt werden. Der Einpreßsockel weist dabei einen Befestigungsbereich auf, auf dem ein Halbleiterchip, beispielsweise durch Löten, befestigt ist. Auf dem Halbleiterchip wiederum ist ebenfalls beispielsweise durch Löten ein sogenannter Kopfdraht befestigt, der elektrisch, beispielsweise durch Löten oder Schweißen, fest mit einer Phasenzuleitung des Kraftfahrzeuggenerators verbunden ist.

Beim Betrieb des Kraftfahrzeugs treten Vibrationen auf, die sich über den Kraftfahrzeuggenerator auf die Gleichrichterdiode übertragen und diese einer erheblichen Zugbelastung aussetzen. Damit diese Zugbelastung vermindert werden kann, ist es bekannt, die Gleichrichterdiode einzukapseln und so einen Formschluß zwischen dem Kopfdraht und dem Einpreßsockel herzustellen. Mit diesem Formschluß soll eine Zugentlastung des empfindlichen Halbleiterchips und der Lotschichten zwischen dem Halbleiterchip und dem Einpreßsockel einerseits und dem Kopfdraht andererseits erreicht werden.

Damit diese Zugentlastung erhöht werden kann, ist bereits vorgeschlagen worden, so beispielsweise in der DE-OS 41 12 286, zusätzliche Mittel vorzusehen, die in die Einkapselung hineinragen. In der DE 41 12 286 ist eine neben dem Halbleiterchip schräg verlaufende Wand beschrieben, die von der Einkapselung umschlossen wird. Die Wand ist dabei in unmittelbarer Nähe des Halbleiterchips angeordnet und weist eine Höhe auf, die den Halbleiterchip überragt. In diese Ausführung kann lediglich über die Höhe der Wand die gewünschte Zugentlastung gesteuert werden. Hierbei ist jedoch nachteilig, daß um so höher die Wand ist, der Halbleiterchip vor Einbringen der Einkapslung abgeschirmt ist, so daß die Chipseitenflächen nach dem Einlöten des Halbleiterchips nur sehr schwer für eine Passivierung zugänglich sind.

Die Druckschrift GB 1 173 737 zeigt Dioden mit einem Kragen, der aus zwei Abschnitten besteht. Insbesondere ist ein Kragen vorgesehen, dessen erster Abschnitt einen von 0 verschiedenen positiven Winkel zur Axialen der Gleichrichteranordnung aufweist. Der darüberliegende Abschnitt ist relativ zur Axialen mit einem negativen Winkel angeordnet, so daß sich eine konvexe Oberfläche des Kragens ergibt.

Vorteile der Erfindung

Die Gleichrichterdiode mit den im Hauptanspruch genannten Merkmalen hat demgegenüber den Vorteil, daß in einfacher Weise eine sichere Zugentlastung der Gleichrichterdiode erreicht wird und ein Zugang eines Passivierungsmittels zu den Seitenflächen des Halbleiterchips nicht erschwert wird. Dadurch, daß an einem äußeren umlaufenden Abschluß des relativ zu einem Randbereich des Einpreßsockels stufenförmig ausgebildeten Befestigungsbereiches, der durchmesserkleiner ist als der Einpreßsockel, ein zu einer Axialen des Befestigungsbereiches abgewinkelt verlaufender, vorzugsweise über eine Befestigungsfläche des Befestigungsbereiches axial hinausragender konkaver Kragen mit zwei Abschnitten mit positiven Winkeln zur Axialen angeordnet ist, kann durch einfache geometrische Variationen des Kragens auf die die Zugentlastung wesentlich beeinflussenden Parameter der Einkapselung Einfluß genommen werden. Insbesondere durch eine vorteilhafte Auswahl der Länge und/oder des Anstellwinkels des Kragens kann eine für die Zugentlastung entscheidende Länge der Einkapselung in Abhängigkeit anderer bekannter Parameter, beispielsweise des Elastizitätsmoduls der Einkapselung eingestellt werden.

In bevorzugter Ausgestaltung der Erfindung ist vorgesehen, daß der Kragen aus einzelnen zueinander beabstandet angeordneten Segmenten gebildet ist, so daß sich zwischen jedem Kragensegment immer eine Lücke ergibt. Durch diese Ausgestaltung ist es sehr vorteilhaft möglich, neben der bereits erwähnten wesentlichen Erhöhung der Zugentlastung für ein ungehindertes Zufließen eines Passivierungsmittels an den Halbleiterchip Sorge zu tragen.

Weitere vorteilhafte Ausgestaltungen der Erfindung ergeben sich aus den übrigen in den Unteransprüchen genannten Merkmalen.

Zeichnung

Die Erfindung wird nachfolgend in Ausführungsbeispielen anhand der zugehörigen Zeichnungen näher erläutert. Es zeigen:

Figur 1    schematisch einen teilweise aufgeschnittenen Querschnitt einer Gleichrichterdiode;

Figur 2    ein Detail aus Figur 1 in einer schematischen Vergrößerung;

Figur 3    eine Ausgestattungsmöglichkeit eines Kragens;

Figur 4    eine Ausführungsform der Erfindung;

Figur 5        eine weitere Ausgestattungsmöglichkeit eines Kragens;

Figur 6        schematisch eine mögliche Herstellung eines Teils der erfindungsgemäßen Gleichrichterdiode und

Figur 7        schematisch einen teilweise aufgeschnittenen Querschnitt einer Gleichrichterdiode in einer weiteren Ausführung.

Beschreibung der Ausführungsbeispiele

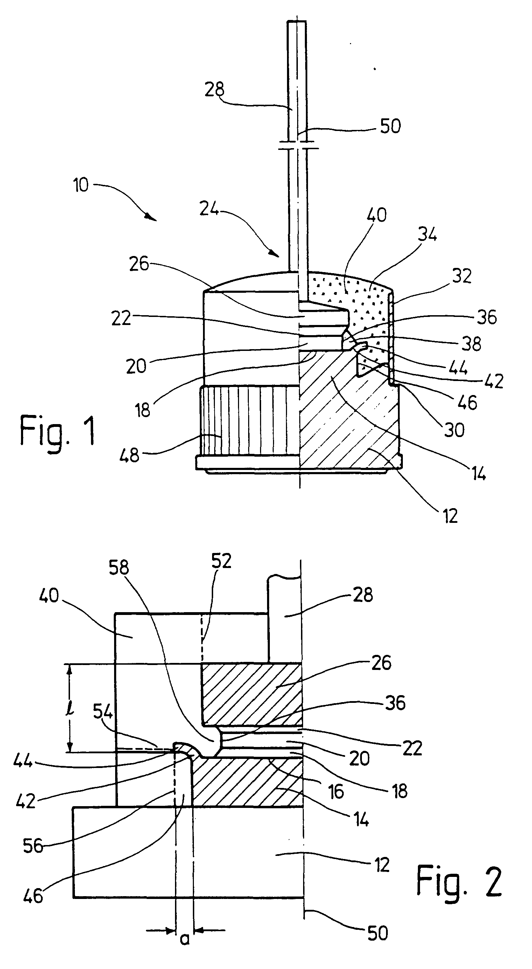

Figur 1 zeigt eine allgemein mit 10 bezeichnete in einem teilweise aufgeschnittenen Querschnitt dargestellte Gleichrichterdiode. Die Gleichrichterdiode 10 besitzt einen Einpreßsockel 12, der in einen sich axial erstreckenden Befestigungsbereich 14 übergeht. Der Befestigungsbereich 14 ist dabei durchmesserkleiner als der Einpreßsockel 12. Der Befestigungsbereich 14 schließt mit einer Befestigungsfläche 16 ab, auf der über ein Lot 18 ein Halbleiterchip 20 befestigt ist. Auf dem Halbleiterchip 20 ist über ein Lot 22 ein Kopfdraht 24 befestigt, wobei der Kopfdraht 24 aus einem Kopf 26 und aus einem mit diesem verbundenen Drahtende 28 besteht. In einer Umfangsnut 30 des Einpreßsockels 12 ist eine Manschette 32 angeordnet, so daß sich innerhalb der Manschette 32 ein Hohlraum 34 ergibt. Der Hohlraum 34 ist so bemessen, daß sich in diesem der Kopf 26 und ein Teil des Drahtendes 28 des Kopfdrahtes 24 befinden. Ein seitlicher Rand 36 des Halbleiterchips 20 ist mit einer Passivierungsschicht 38 versehen. Der Hohlraum 34 ist mit einer Einkapselung 40, beispielsweise aus einem Gießharz, verfüllt. Der Befestigungsbereich 14 weist weiterhin an einem äußeren umlaufenden Abschluß 42 einen Kragen 44 auf. Der Kragen 44 ragt dabei in die Einkapselung 40 hinein, so daß sich unterhalb des Kragens 44 eine Hinterschneidung 46 ergibt. An seinem Außenumfang kann der Einpreßsockel eine Rändelung 48 aufweisen.

Bei der in der in Figur 1 gezeigten Gleichrichterdiode 10 ist für die Erfindung wesentlich, wobei auf Details in den weiteren Figuren noch näher eingegangen wird, daß der Kragen 44 in die Einkapselung 40 eingreift, das heißt von dieser umschlossen wird und somit insgesamt ein Formschluß zwischen dem Kopfdraht 24 und dem Einpreßsockel 12 realisiert ist. Durch diesen Formschluß werden insbesondere der Halbleiterchip 20 und die Lote 18 bzw. 22 zugentlastet. In dem Moment, wo an dem Drahtende 28 eine Phasenzuleitung eines hier nicht dargestellten Kraftfahrzeuggenerators angeschlossen ist, werden die zwangsläufig auftretenden Vibrationen des Kraftfahrzeugs über den Kopfdraht 24 auf den Halbleiterchip 20 und die Lote 18 und 22 übertragen. Somit ist dieser Bereich einer erheblichen Zugbelastung ausgesetzt, die zu einem Ablösen des Halbleiterchips 20 führen würden, wenn nicht eine ausreichende Zugentlastung geschaffen ist.

Anhand einer vergrößerten Darstellung dieses Bereiches wird in der Figur 2 der Aufbau und die Wirkungsweise weiter verdeutlicht. Gleiche Teile wie in Figur 1 sind mit gleichen Bezugszeichen versehen und hier nicht nochmals erläutert. Es ist deutlich der von dem äußeren Abschluß 42 des Befestigungsbereiches 14 ausgehende Kragen 44 zu erkennen. Der Kragen 44 ist von der, Einkapselung 40 umschlossen und verankert somit die Einkapselung 40 über dem Kopf 26 und dem Befestigungsbereich 14. Die Einkapselung 40 ist somit durch einen Gießharzzylinder gebildet, der sich den von dem Kopf 26 und Befestigungsbereich 14 vorgegebenen Außenkonturen anpaßt und diese formschlüssig umgreift. Für eine Zugentlastung entlang der Axialen 50 ist hier ein mit einer Länge 1 gekennzeichneter Bereich der Einkapselung 40 entscheidend. Bei einer Zugbelastung zwischen dem Kopfdraht 24 und dem Einpreßsockel 12 bzw. dem Befestigungsbereich 14 wird der Bereich mit der Länge 1 um eine Länge Δ 1 gedehnt. Die Zugentlastung ist um so wirksamer, je kleiner Δ1 bei vorgegebener Zugkraft wird. Nach der Hookeschen Formel

$$\Delta l = \frac{\sigma}{E} \cdot l$$

ist Δl proportional der Länge l und umgekehrt proportional einem durch E symbolisierten Elastizitätsmodul der Einkapselung 40. Der Wert σ steht hier für eine vorgegebene und damit konstante Spannung.

Durch eine entsprechende Auswahl der Einkapselung 40 und damit des Elastizitätsmoduls E der Einkapselung 40 und eine möglichst kleine Länge 1 können somit hohe Zugentlastungen eingestellt werden. Durch eine Variation des Kragens 44 kann somit direkt auf die Länge 1 Einfluß, genommen werden. Indem der Kragen 44 über die Befestigungsfläche 16 in axialer Richtung verlängert ist, kann die Länge 1 weiter reduziert werden. Auf Einzelheiten hierzu wird in den nachfolgenden Figuren noch eingegangen. Die zwischen dem Kopfdraht 24 und dem Einpreßsockel 12 wirkende Zugbelastung muß durch eine erste Zylinderfläche 52, eine zweite Zylinderfläche 56 und eine Kreisringfläche 54 aufgenommen werden. Die tragende Kreisringfläche 56 kann sehr vorteilhaft einerseits durch Wahl einer Stufenhöhe des Befestigungsbereiches 14 und andererseits durch eine Wahl der Anformung des Kragens 44 eingestellt werden. Ebenso kann die Kreisringfläche 54 durch Auswahl eines Abstandes a, eines äußeren Abschlusses des Kragens 44 eingestellt werden. Um so größer der Abstand a gewählt wird, desto geringer wird die Kreisringfläche 54 und um so größer wird der die Hinterschneidung 46 bildende Bereich der Einkapselung 40.

In einen von dem Kragen 44 dem Halbleiterchip 20 und dem Kopf 26 eingeschlossenen Bereich 58 kann vor Einbringen der Einkapselung 40 problemlos eine Ätzlösung eingebracht werden, mit der der Rand 36 des Halbleiterchips 20 nach dem Einlöten gereinigt werden muß, um niedrige Sperrströme zu erzeugen. Ein Einbringen der in Figur 1 gezeigten Passivierungsschicht 38 ist ebenfalls problemlos möglich.

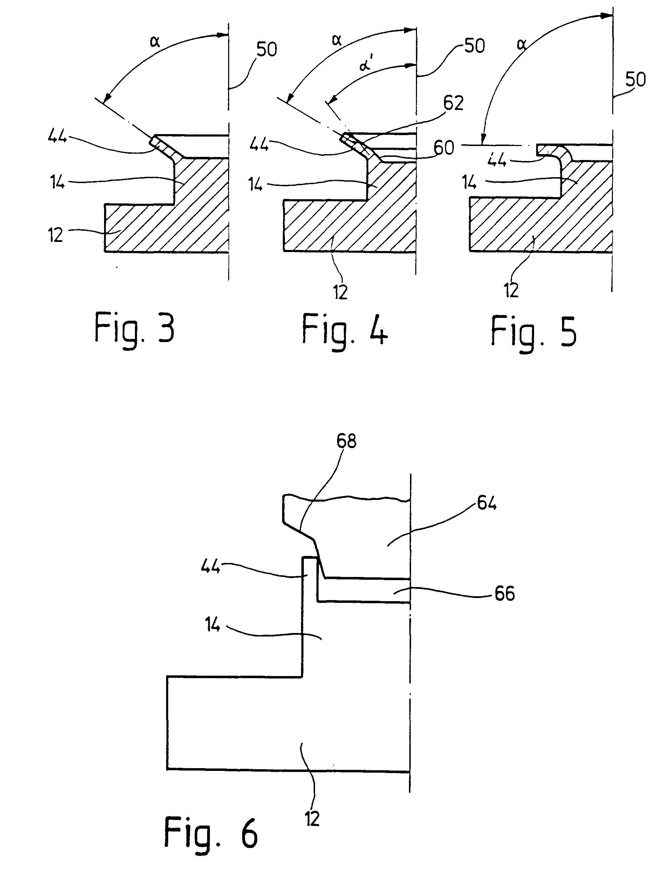

In den Figuren 3 bis 5 sind verschiedene Ausgestaltungsmöglichkeiten eines Kragens 44 verdeutlicht. Gleiche Teile sind wieder mit gleichen Bezugszeichen versehen. In der Figur 3 wird deutlich, daß der Kragen 44 einstückig mit dem Befestigungsbereich 14 ausgebildet ist. Der Kragen 44 ist hier unter einem Winkel α zu der Axialen 50 abgewinkelt. Durch Wahl des Winkels α kann die in Figur 2 beschriebene Länge 1 sowie die Zylinderfläches 56 und die Kreisringfläche 54 eingestellt werden. Es ist also durch eine einfache Auswahl eines Winkels α ein direkter Einfluß auf die Zugentlastung möglich.

In der Figur 4 wird deutlich, daß der Kragen 44 erfindungsgemäß einen ersten Abschnitt 60 und einen zweiten Abschnitt 62 aufweisen kann. Die Abschnitte 60 und 62 sind dabei mit einem unterschiedlichen Winkel α bzw. α' zu der Axialen 50 angeordnet. Durch Variation verschiedener Winkel α bei einem Kragen 44 kann das Zugentlastungsverhalten der gesamten Gleichrichterdiode 10 sehr variabel eingestellt werden. Insbesondere wird auch eine bessere Zugänglichkeit des in Figur beschriebenen Bereiches 58 für die Ätzlösung bzw. die Passivierungsschicht erreicht.

Figur 5 zeigt einen Kragen 44, der als Umbördelung ausgebildet ist. Durch die hier gezeigte einfach herzustellende Umbördelung des Kragens 44 ist ein sehr großer Winkel α, hier von 90°, realisierbar, so daß zwar einerseits die Länge 1 vergrößert wird, jedoch durch eine Einstellung der Zylinderfläche 56 und der Kreisringfläche 54 die Zugentlastung insgesamt positiv beeinflußt werden kann. Anhand der Figur 6 wird die Herstellung der in den Figuren 3 bis 5 beispielhaft dargestellten Kragen 44 verdeutlicht. Da der Einpreßsockel 12 in der Regel rotationssymmetrisch ausgebildet ist, kann der gesamte Einpreßsockel 12 mit seinem Befestigungsbereich 14 und einer später den Kragen 44 ergebenden umfangsseitigen Verlängerung des Befestigungsbereiches 14 als Drehteil in einfacher Weise hergestellt werden. Durch Einführen eines Formwerkzeuges 64 in einem von dem noch nicht verformten Kragen 44 gebildeten Hohlraum 66 kann der Kragen 44 in gewünschter Weise an dem Befestigungsbereich 14 angeformt werden. Eine Arbeitsfläche 68 des Formwerkzeuges 64 ist dabei so ausgebildet, daß die in den Figuren 3 bis 5 beispielhaft gezeigten Konturen des Kragens 44 entstehen. Insgesamt ist es also möglich, den Einpreßsockel 12 ohne eine spanende Bearbeitung des bereits vorgefertigten Drehteils in die endgültige Form zu bringen.

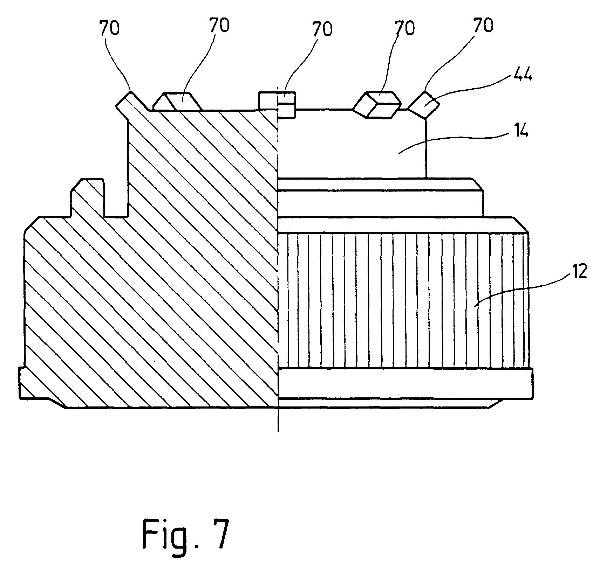

Figur 7 zeigt in einem teilweise aufgeschnittenen Querschnitt eine weitere Ausführungsvariante des Einpreßsockels 12. Der an dem Befestigungsbereich 14 angeformte Kragen 44 wird hier durch einzelne Kragensegmente 70 gebildet, die auf dem äußeren Abschluß 42 des Befestigungsbereiches 14 beabstandet zueinander angeordnet sind. Der Abstand zwischen den einzelnen Segmenten 70 ist dabei frei wählbar und entsprechend der gewünschten Zugentlastung einstellbar. Durch diese Ausgestaltung wird erreicht, daß einerseits die hier den Kragen 44 bildenden Segmente 70, wie bereits zu den Figuren 1 bis 6 erwähnt, direkten Einfluß auf die Zugentlastung der Gleichrichterdiode 10 nehmen und andererseits durch die Zwischenräume zwischen den Segmenten 70 ein sehr verbessertes Heranführen der Ätzlösung bzw. der Passivierungsschicht an den Rand 36 des Halbleiterchips 20 möglich ist. Die Segmente 70 können die in den Figuren 3 bis 5 beispielhaft gezeigten Konturen ebenfalls aufweisen.

**Patentansprüche**

1. Gleichrichterdiode mit einem Einpreßsockel, der einen sich axial erstreckenden Befestigungsbereich für einen Halbleiterchip aufweist, wobei der einstückig mit dem Einpreßsockel verbundene Befestigungsbereich durchmesserkleiner ist als der Einpreßsockel, einem auf dem Halbleiterchip befestigten Kopfdraht, einer Einkapselung (40) des Kopfdrahtes sowie einem an einem äußeren umlaufenden Abschluß (42) des Befestigungsbereiches (14) angeordneten, zu einer Axialen (50) des Befestigungsbereiches (14) abgewinkelt verlaufenden, über die Befestigungsfläche (16) des Befestigungsbereiches (14) hinausragenden Kragen (44), wobei der Kragen (44) einstückig mit dem Befestigungsbereich (14) ausgebildet und ein erster Abschnitt (60) des Kragens (44) zu der Axialen (50) in einem von Null verschiedenen positiven Winkel α' angeordnet ist, **dadurch gekennzeichnet, daß** ein folgender zweiter Abschnitt (62) des Kragens einen zum ersten Abschnitt (60) unterschiedlichen, von Null verschiedenen positiven Winkel α aufweist, wobei α > α' ist, und **daß** der Befestigungsbereich stufenförmig ausgebildet ist relativ zu einem Randbereich des Einpreßsockels.

2. Gleichrichterdiode nach Anspruch 1, **dadurch gekennzeichnet, daß** eine Manschette (32) die Einkapselung (40) umschließt.

3. Gleichrichterdiode nach Anspruch 1 oder 2, **dadurch gekennzeichnet, daß** die Abschnitte (60; 62) bogenförmig ineinander übergehen.

4. Gleichrichterdiode nach Anspruch 1 oder 2, **dadurch gekennzeichnet, daß** die Abschnitte (60; 62) winklig ineinander übergehen.

5. Gleichrichterdiode nach einem der vorhergehenden Ansprüche, **dadurch gekennzeichnet, daß** über eine entsprechend gewählte Länge des Kragens (44), insbesondere des äußeren Abschnitts (62), eine Zylinderfläche (54) der Einkapselung (40) festgelegt ist.

**6.** Gleichrichterdiode nach einem der vorhergehenden Ansprüche, **dadurch gekennzeichnet, daß** über den Winkel (α) eine Kreisringfläche (56) der Einkapselung (40) festgelegt ist.

**7.** Gleichrichterdiode nach einem der vorhergehenden Ansprüche, **dadurch gekennzeichnet, daß** die Einkapselung (40) durch einen Gießharzzylinder gebildet ist.

**8.** Gleichrichterdiode nach einem der vorhergehenden Ansprüche, **dadurch gekennzeichnet, daß** über den Winkel (α) und/oder die Länge des Kragens (44) eine Länge (1) eines Dehnungsbereiches der Einkapselung (40) festgelegt ist.

**9.** Gleichrichterdiode nach einem der vorhergehenden Ansprüche, **dadurch gekennzeichnet, daß** der Kragen (44) aus einzelnen zueinander beabstandet angeordneten Segmenten (70) gebildet ist.

## Claims

**1.** Rectifier diode having a press-fit base which has an axially extending mounting region for a semiconductor chip, the diameter of the mounting region, which is integrally connected to the press-fit base, being smaller than that of the press-fit base, having a head wire which is mounted on the semiconductor chip, having a casing (40) for the head wire and also having a collar (44) which is arranged on an outer circumferential termination (42) of the mounting region (14), runs at an angle to an axis (50) of the mounting region (14) and projects over the mounting surface (16) of the mounting region (14), the collar (44) being designed to be an integral part of the mounting region (14), and a first portion (60) of the collar (44) being arranged at a non-zero positive angle α' to the axis (50), **characterized in that** a succeeding second portion (62) of the collar has a non-zero positive angle α which differs from that of the first portion (60), with α > α', and **in that** the mounting region is of stepped design relative to an edge region of the press-fit base.

**2.** Rectifier diode according to Claim 1, **characterized in that** a sleeve (32) surrounds the casing (40).

**3.** Rectifier diode according to Claim 1 or 2, **characterized in that** the portions (60; 62) merge into one another arcuately.

**4.** , Rectifier diode according to Claim 1 or 2, **characterized in that** the portions (60; 62) merge into one another angularly.

**5.** Rectifier diode according to one of the preceding claims, **characterized in that** a cylindrical surface (54) of the casing (40) is defined over an appropriately chosen length of the collar (44), in particular of the outer portion (62).

**6.** Rectifier diode according to one of the preceding claims, **characterized in that** an annular surface (56) of the casing (40) is defined over the angle (α).

**7.** Rectifier diode according to one of the preceding claims, **characterized in that** the casing (40) is formed by a moulded resin cylinder.

**8.** Rectifier diode according to one of the preceding claims, **characterized in that** a length (1) of an extension region of the casing (40) is defined over the angle (α) and/or over the length of the collar (44).

**9.** Rectifier diode according to one of the preceding claims, **characterized in that** the collar (44) is formed from individual segments (70) arranged at a distance from one another.

## Revendications

**1.** Diode de redressement avec un socle d'insertion comportant une zone de fixation dans le sens axial pour une semiconducteur, dans laquelle la zone de fixation d'une seule pièce avec le socle d'insertion a un diamètre inférieur à celui du socle d'insertion, avec un câble de tête fixé sur le semi-conducteur, avec un enrobage (40) du câble de tête ainsi qu'un rebord (44) monté sur une bordure périphérique extérieure (42) de la zone de fixation (14), coudé en s'écartant d'un axe (50) de la zone de fixation (14), en saillie par rapport à une surface de fixation (16) de la zone de fixation (14), ce rebord (44) faisant avec la zone de fixation (14) une pièce unique et un premier segment (60) du rebord (44) faisant un angle positif α' différent de zéro par rapport à l'axe (50),
**caractérisée en ce qu'**
un deuxième segment suivant (62) du rebord fait par rapport au premier segment (60), un angle positif α différent de zéro, avec α > α', et la zone de fixation est de forme étagée par rapport à une zone d'extrémité du socle d'insertion.

**2.** Diode de redressement selon la revendication 1, **caractérisée en ce qu'** une manchette (32) entoure l'enrobage (40).

**3.** Diode de redressement selon la revendication 1 ou 2,

**caractérisée en ce que**
les segments (60, 62) sont dans le prolongement
l'un de l'autre en formant un arc.

4.  Diode de redressement selon la revendication 1 ou
    2,
    **caractérisée en ce que**
    les segments (60, 62) sont dans le prolongement
    l'un de l'autre en formant un angle.

5.  Diode de redressement selon l'une quelconque des
    revendications précédentes,
    **caractérisée en ce que**
    sur une longueur convenablement choisie du rebord (44), particulièrement du segment extérieur
    (62), est disposée une surface cylindrique (54) de
    l'enrobage (40).

6.  Diode de redressement selon l'une quelconque des
    revendications précédentes,
    **caractérisée en ce que**
    sur l'angle ($\alpha$) est disposée une surface annulaire
    (56) de 1' enrobage (40).

7.  Diode de redressement selon l'une des revendications précédentes,
    **caractérisée en ce que**
    l'enrobage (40) est constitué par un cylindre en résine coulée.

8.  Diode de redressement selon l'une quelconque des
    revendications précédentes,
    **caractérisée en ce que**
    sur l'angle ($\alpha$), et/ou sur la longueur du rebord (44),
    est disposée une longueur ($\ell$) d'une zone de dilatation de l'enrobage (40) .

9.  Diode de redressement selon l'une quelconque des
    revendications précédentes,
    **caractérisée en ce que**
    le rebord (44) est formé par des segments (70) indépendants, à une certaine distance l'un de l'autre.

Fig. 1

Fig. 2

Fig. 3

Fig. 4

Fig. 5

Fig. 6

Fig. 7